Europäisches Patentamt

European Patent Office

Office européen des brevets

(11) Publication number: **0 049 588**
**B1**

## EUROPEAN PATENT SPECIFICATION

(45) Date of publication of patent specification: **21.08.85**

(21) Application number: **81304409.6**

(22) Date of filing: **24.09.81**

(51) Int. Cl.⁴: **H 02 N 13/00,** H 01 L 21/68, H 01 J 37/20

(54) Method and apparatus for dry etching and electrostatic chucking device used therein.

(30) Priority: **30.09.80 JP 136255/80**
**08.10.80 JP 141046/80**

(43) Date of publication of application:
**14.04.82 Bulletin 82/15**

(45) Publication of the grant of the patent:
**21.08.85 Bulletin 85/34**

(84) Designated Contracting States:
**DE FR GB NL**

(56) References cited:
**US-A-3 634 740**
**US-A-3 916 270**
**US-A-4 184 188**

(73) Proprietor: **FUJITSU LIMITED**
**1015, Kamikodanaka Nakahara-ku
Kawasaki-shi Kanagawa 211 (JP)**

(72) Inventor: **Abe, Naomichi
15-14-802, Yoga 3-chome
Setagaya-ku Tokyo 158 (JP)**

(74) Representative: **Abbott, Leonard Charles et al
GILL JENNINGS & EVERY 53-64 Chancery Lane
London WC2A 1HN (GB)**

## Description

The present invention relates to a method and an apparatus for dry etching and, an electrostatic chucking device used for said dry etching method, and in detail, a method and an apparatus for controlling the temperature of a material to be etched effectively and etching when dry etching is performed using a plasma etching apparatus, a sputter etching apparatus or a reactive sputter etching apparatus, and, an electrostatic chucking device used for said dry etching method and holding and fixing the material to be etched. The method and apparatus according to the present invention can be used for the production of, for example, semiconductor integrated circuits.

Dry etching is the known technique by which materials to be etched such as Si, $SiO_2$, $Si_3N_4$, Al, W, Mo, Ti and the alloys of these metals and the like are etched using a plasma etching apparatus, a sputter etching apparatus or a reactive sputter etching apparatus. Particularly the dry etching technique has the following advantages:

(I) optically sensitive resin can be used as an etching mask,

(II) the undercut of the material to be etched is small, thus the fine profiled pattern can be formed at the etching,

(III) the contamination by impurities at the liquid etching method, can be protected.

(IV) the etching control characteristic is excellent, and is widely used as compared with the etching method using etching liquid.

In recent years, in accordance with the speedup of production on a production line, it is desired to etch at high speed. However, in order to try to speedup the dry etching, the applied electric power must be high, therefore, the heat generated by the plasma discharge is increased and when the temperature of the material to be etched is raised and comes up to approximately 100 degrees centigrade, deterioration or melting and so on of the resist which is used for the mask occurs and normal etching cannot be performed. The above-mentioned problems have remained without solution. These problems are more important in sputter etching or reactive sputter etching in which the material to be etched is given ion impingement. Therefore, in these cases it is necessary to cool the material to be etched.

Contrary to the above-mentioned cases, in some cases the high temperature of the material to be etched is advantageous. For example, one advantageous case is the case in which the vapor pressure of the reactive products is excessively low at normal temperature when the plasma etching or the reactive sputter etching is performed. During etching it is necessary to remove the reactive products quickly. Therefore, in the above-mentioned case, it is advantageous to increase the vapor pressure of the reactive products by raising the temperature of the material to be etched, and for this reason sometimes the supporting base is heated.

In either of the above-mentioned cases, the putting of the material to be etched on the supporting base which is temperature controlled, is not in itself sufficient and it is desirable for the supporting base to contact closely the material to be etched so that the temperature of the supporting base can be conducted to the material to be etched with high conductivity. For example, when the material to be etched is a semiconductor wafer, the wafer has warps the length of which is tens of micrometers, therefore, the wafer must be pressed, the warps must be corrected and the contact area must be increased. Besides, in the case of etching aimed at a fine profiled pattern processing, the adherence of dust to the material to be etched causes serious problems, to avoid these problems it is preferable that the material to be etched, if possible, is etched while being held upside down or on its side.

The method of holding and fixing the object, the so called method of chucking, usually makes use of a mechanical chuck. When a mechanical chuck cannot be made use of or its use is undesirable, a method using a vacuum chuck, an electrostatic chuck or the like is proposed. The electrostatic chuck is based on the principle of electrostatic attracting force and is advantageous for materials to be etched which are comparatively light and require treatment in a vacuum condition.

Particularly in the semiconductor device producing process, the electrostatic chuck is useful. For example, processes such as vacuum evaporation, chemical vapor deposition (CVD), etching or the like are performed under a vacuum condition or extremely low air pressure, therefore, the vacuum chuck cannot be made use of. The mechanical chuck, no matter what form the chuck takes, covers a part of the wafer by means of the arm of the chuck and at that part of wafer where the semiconductor device cannot be produced, the mechanical chuck method is not a desirable method. The mechanical chuck applies the force for holding to only a portion of the wafer, thus it is inadequate to accomplish the object of reforming and making flat the warps by pressing. The electrostatic chuck can be used under the vacuum condition, as it needs no arm to hold the processing material, and the holding force is applied uniformly and thus the electrostatic chuck method has many advantages in the semiconductor device producing processes.

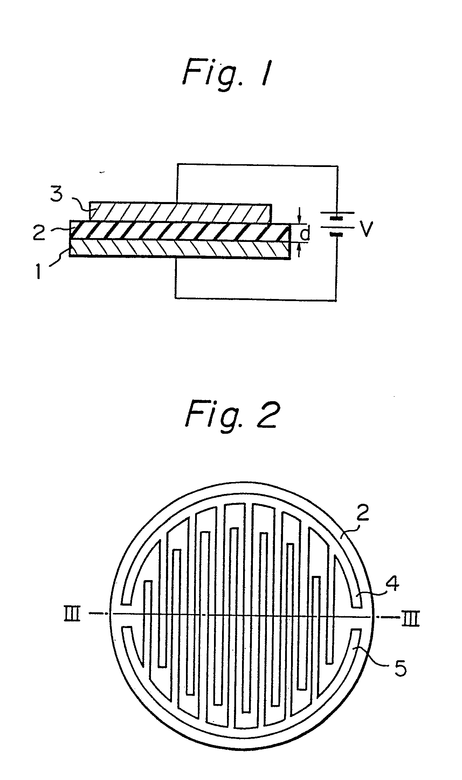

As electrostatic chucks i.e. electrostatic chucking devices, already the following two types have been proposed. One of the electrostatic chucking devices, as shown in Fig. 1, has a plane electrode 1 on which a material to be chucked 3 is located with an insulator 2 inserted therebetween, and voltage is applied between the electrode 1 and the material to be chucked 3, then the material to be chucked 3 is attracted. The attracting force F is shown by the following equation (1).

$$F = \frac{1}{2} \cdot \varepsilon \cdot \frac{V^2}{d^2} \cdot S \qquad\qquad (1)$$

Where, $\varepsilon$ is the dielectric constant, V is the applied voltage, d is the thickness of the insulator layer, and S is the area of the electrode.

In this method, since the voltage is applied between a material to be chucked 3 and the electrode 1, electrical contact with the material to be chucked is requried. For this reason, the material to be chucked 3 is limited to the conductor, the semiconductor, or at least the material covered with conductive material on the surface thereof. Therefore, the semiconductor wafer covered with an insulator such as $SiO_2$ film cannot be treated in the above mentioned method.

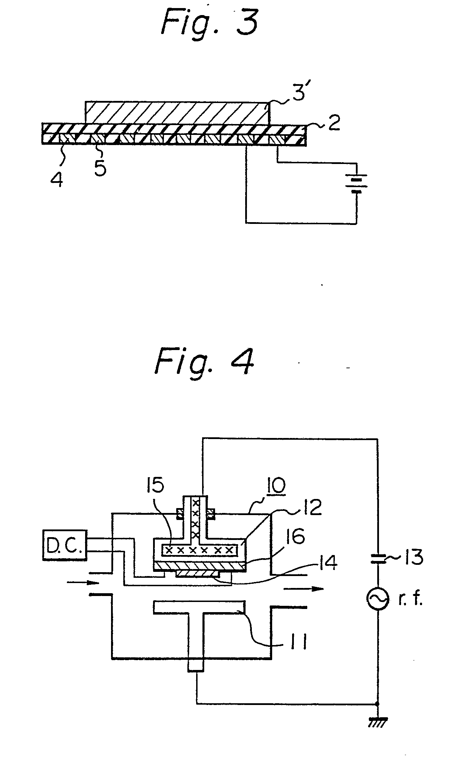

The other example is shown in Figs. 2 and 3. This example has electrodes 4 and 5 which are comb-shaped and interdigitated. On the electrodes 4 and 5 the material to be chucked 3' is located with the insulator 2 inserted therebetween. This type of electrostatic chuck is proposed to be a device which attracts an insulator such as a sheet of paper. In this example, since the interval between a pair of electrodes is designed to be extremely narrow, a strong electric field is generated between the electrodes. In this method the principle of attraction is the attractive force between the polarized charges is induced on to the material to be chucked 3' and on the electrodes. This method is also made use of in the case of chucking conductive materials. Thus it has a wider application than the previous method; however the attracting force is weaker than the attracting force in the method of Fig. 1.

Examples of the use of comb-like interdigitated electrodes are shown in US—A—3916270, which is concerned with an electrostatic hold-down device for clamping papers; US—A—3634740, which also relates to a hold-down device; and US—A—4184188, which discloses the use of an electrostatic clamping device in a process of ion-milling (etching).

An object of the present invention is to provide an electrostatic chucking device which can be applied to electrically conductive materials such as a semiconductor wafer including conductor and semiconductor, and to electrically conductive materials covered with thin insulating film on the surface thereof, and which chucking device has a simple structure but a stronger attracting force than previous comb-like interdigitated devices such as that of Figures 2 and 3.

Another object of the present invention is to provide a method and an apparatus for dry etching which can chuck the material to be etched to the supporting base and make a good thermal contact between the material to be etched and the supporting base by using the electrostatic chucking device to hold and fix the material to be etched, by plasma etching, sputter etching or reactive sputter etching, whereby the temperature of the material to be etched is controlled effectively and the material to be etched can be held upside down or on its side.

According to one aspect of the present invention, there is provided an electrostatic device for chucking a material having at least a conductive portion, comprising a sheet of insulator and a pair of plane electrodes positioned on a first of the two surfaces of the sheet of insulator in close contact with the sheet, the plane electrodes being electrically isolated from each other, and voltage being supplied between the pair of plane electrodes from an external voltage source such that the plane electrodes are capable of chucking the conductive material on the second surface of the sheet of insulator, characterized in that the sum of the areas of the portions of the pair of plane electrodes which face the conductive material is approximately equal to the contact area between the said material and the sheet of insulator when the material is chucked.

An apparatus embodying the invention for dry etching of a material having at least a conductive portion and using a sputter etching apparatus, a reactive sputter etching apparatus or a plasma etching apparatus, further comprises: a supporting base the temperature of which is maintained at a predetermined value, an electrostatic chucking device in accordance with the invention mounted on the supporting base, and as etching chamber to which gases are supplied and to which electric power is applied to form a plasma for etching.

The invention also consists in a method for dry etching a material having a conductive portion, comprising placing the material to be etched on an electrostatic device positioned on a supporting base the temperature of which is maintained at a predetermined value, the electrostatic device having a sheet of insulator and a pair of plane electrodes positioned on one surface of the sheet of insulator in close contact with the sheet, the plane electrodes being electrically isolated from each other, and a voltage being applied between the pair of plane electrodes of the electrostatic device from an external power source to cause the material to be chucked electrostatically to the opposite surface of the sheet of insulator and thereby indirectly fixed to the supporting base; the method is characterized in that the sum of the area of the portions of the pair of plane electrodes facing the direction of the material is approximately equal to the contact area between the material and the sheet of insulator when the material is chucked and in that the electrostatic device and supporting base are positioned in the etching chamber of a sputter etching apparatus, reactive sputter etching apparatus, or a plasma etching apparatus, an etching gas is introduced into the said chamber and an electric field is formed in the chamber by a power source to form a plasma.

With all of these forms of the invention, it is preferable that the areas of the portions of the two

**0 049 588**

electrodes which face the material are approximately equal, so that the areas of the parallel-plate capacitors so formed are equal and the force attracting the material to the inuslator is maximised.

In order that the invention may be better understood, three embodiments are described below, with reference to the accompanying drawings wherein:—

Figure 1, to which reference has already been made, is a side view illustrating one conventional electrostatic chucking device;

·Figure 2, also referred to above, is a plan view illustrating another example of a conventional electrostatic chucking device;

Figure 3, also referred to above, is a cross-sectional view taken along the line III—III of figure 2 showing an electrostatic chucking device;

Figure 4 is a diagrammatic view illustrating a reactive sputter etching apparatus;

Figure 5 is a side view illustrating an electrostatic chucking device according to an embodiment of the present invention;

Figure 6 is a detailed view of the device in figure 5;

Figure 7 is a cross-sectional view taken along the line VII—VII of the device in figure 6;

Figure 8 is a plan view of electrodes of an electrostatic chucking device according to another embodiment of the present invention;

Figure 9 is a plan view of electrodes of an electrostatic chucking device according to a further embodiment of the present invention;

Figure 10 is an equivalent circuit diagram of the electrostatic chucking device of figure 5.

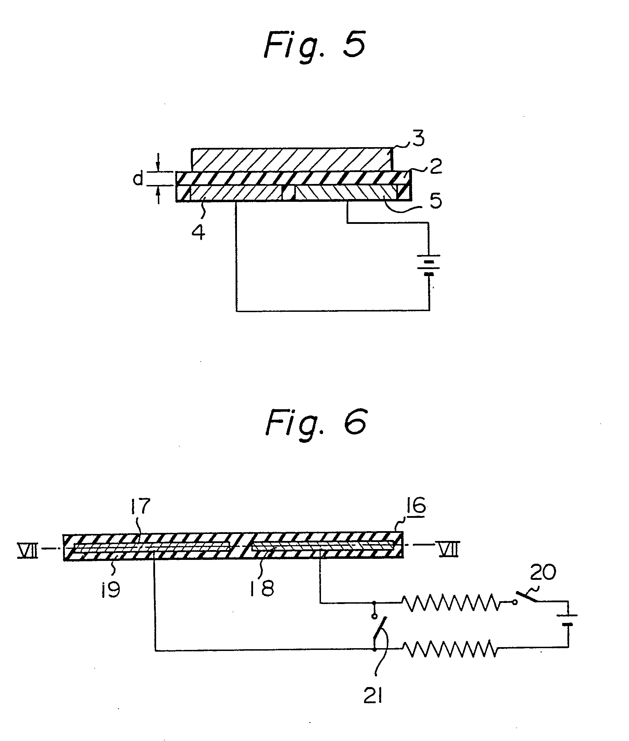

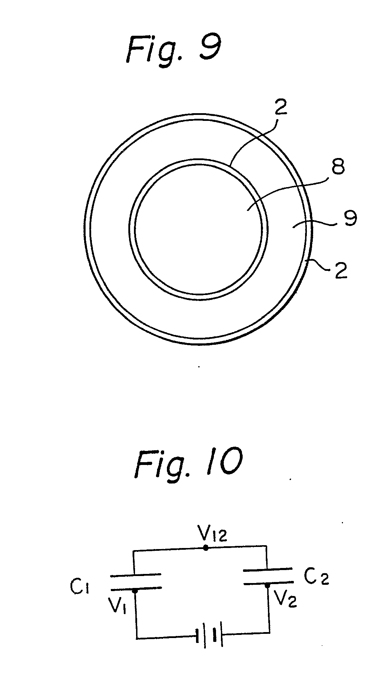

The principle of the electrostatic chucking device according to the present invention is explained below. Fig. 10 is an electrically equivalent circuit of the circuit mentioned below in Fig. 5. Since the material to be chucked 3 is conductive, the electrostatic capacities C1 and C2 exist between the material to be chucked 3 and the electrodes 4 and 5, respectively, and the material to be chucked and electrodes can be considered to form parallel-plate condensers. These condensers are connected in series through the lines illustrated in Fig. 5 and the material to be chucked 3.

If the electrical potentials of the electrodes 4 and 5 are V1 and V2, respectively, and the electrical potential of the material to be chucked is V12, V12 is shown as the following equation.

$$V12 = \frac{C1}{C1+C2} V1 + \frac{C2}{C1+C2} V2 \qquad (2)$$

It has been known that when the voltage is applied across the condenser, the electrostatic force operates between the electrodes of the condenser, and the value of the electrostatic force is indicated in the equation (1). When the voltages being applied across the condenser C1 and C2 are (V12−V1) and (V12−V2), respectively, and the electrode areas of the condenser C1 and C2 are S1 and S2, respectively, the electrostatic attracting force F(C1, C2) is shown as the following equation.

$$F(C1,\ C2) = \frac{1}{2} \frac{\varepsilon}{d^2} \{(V12-V1)^2 S1 + (V12-V2)^2 S2\} \qquad (3)$$

Where, the equations

$$C1 = \frac{\varepsilon S1}{d}, \qquad C2 = \frac{\varepsilon S2}{d} \qquad (4)$$

are substituted for the equation (2), and the equation (2) is substituted for the equation (3), thus, F(C1, C2) is shown as the following equation (5).

$$F(C1,\ C2) = \frac{1}{2} \frac{\varepsilon}{d^2} \frac{S1\ S2}{S1+S2} (V2-V1)^2 = \frac{1}{2} \frac{\varepsilon}{d^2} \frac{S1\ S2}{S1+S2} V^2 \qquad (5)$$

where

$$V = |\ V1-V2\ | \qquad (6)$$

As can be understood from the equation (5), it is found that the attracting force is proportional to the dielectric constant and the area of the electrode, is proportional to the square of the voltage and is inversely proportional to the square of the insulator thickness. F(C1, C2) becomes maximum when

$$S1 = S2 = \frac{S1+S2}{2} = \frac{S}{2},$$

and in this case F(C1, C2) is shown as the equation (7).

4

$$F(C1, C2) == \frac{\varepsilon}{8} \frac{V^2}{d^2} \cdot S \qquad (7)$$

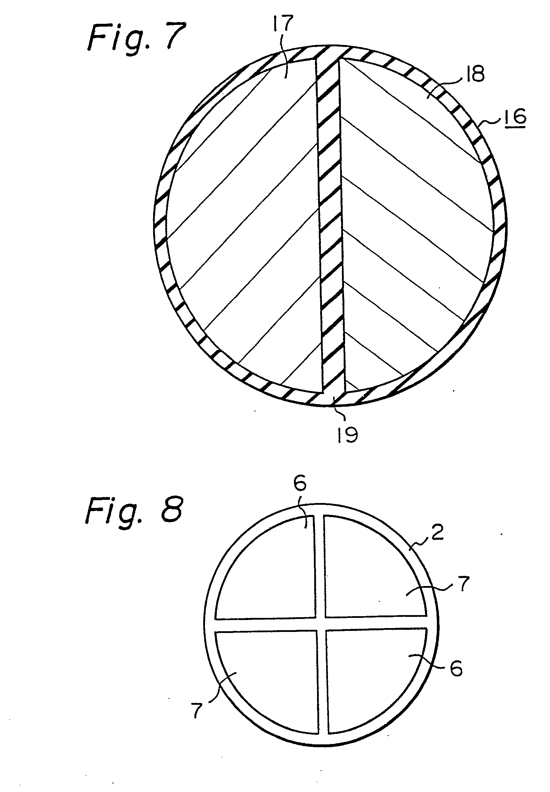

Figure 5, shows a cross-sectional view and wiring diagram of an electrostatic chucking device according to a first embodiment of the present invention. The plan view of electrodes in the electrostatic chucking device in figure 5 is similar to that in figure 7. A material to be chucked 3 can be attracted by applying approximately 1000 to 5000 volts between a pair of plane electrodes 4 and 5. For example, electrodes made of aluminium can be used as electrodes 4 and 5, the insulator made of material such as polytetrafluoroethylene or polyethylene can be used as the insulator 2, which is preferably approximately 50 to 200 micrometers thick.

[Experiment 1]
The performance of the following electrostatic chucking devices is compared, namely, a conventional device (1), another conventional device (2) and a device according to the present embodiment of the invention, by referring to the results of the experiment herein below. In the devices used for the experiment, the area of the chucking portion is 100 square centimeters and the thickness of the insulator is 100 micrometers. Polyethylene is used as the material of the insulators, and aluminium plates, silicon wafers, silicon wafers with $SiO_2$ film of 1 micrometer and quartz plates are used as the material to be chucked. An applied voltage is 1000 volts.

The results of the above-mentioned experiment regarding the electrostatic chucking device are shown in the following table.

TABLE
Electrostatic chucking force (gram-weight)

|  |  | The material to be etched | | | |
|---|---|---|---|---|---|
|  |  | Al plate | Si wafer | Si wafer+$SiO_2$ | Quartz plate |
| Electrostatic chucking device | Conventional ex. (1) | 1130 | 1210 | 0 | 0 |
|  | Conventional ex. (2) | 140 | 130 | 130 | 20 |
|  | Present embodiment | 310 | 290 | 310 | 0 |

Conventional ex. (1): Device in Fig. 1
Conventional ex. (2): Device in Fig. 2.

It is found from the table that the electrostatic chucking device according to the present embodiment can be applied in all cases in which conductors, semiconductors, and conductors and semiconductors covered with thin insulating film on the surface are treated, and the attracting force of the electrostatic chucking device according to the present embodiment is weaker than the attracting force of the conventional electrostatic chucking device in Fig. 1. However, it is about twice as strong as the conventional electrostatic chucking device of Figs. 2 and 3. According to the conclusion obtained from the discussion of the above-mentioned characteristics, the electrostatic chucking device according to the present embodiment is the most advantageous of the above three examples as an electrostatic chucking device for treating a semiconductor wafer covered with insulating film, such as $SiO_2$ or $Si_3N_4$ films, and also is advantageous for manufacturing the device since the structure of the device is simple.

In Figs. 8 and 9, the other embodiments of the electrostatic chucking device according to the present invention are shown. In these embodiments, the shapes of the electrodes are changed from the shape of the electrodes in Fig. 7. The shape of the electrodes in Fig. 8 is divided into four parts and electrodes 6 and 7 are symmetrical regarding a center point, and in Fig. 9, an example having concentric-form electrodes 8 and 9 is shown.

Fig. 4 is a diagrammatic view of a reactive sputter etching apparatus 10 using generally a method for dry etching according to the present invention. In Fig. 4 an anode 11 is grounded and a cathode 12 is applied to the high frequency voltage (r.f.) through a condenser 13, and then etching is performed. The material to be etched 14 is attracted to the cathode 12 by an electrostatic chucking device 16. Namely, the cathode 12 is also the supporting base of the material to be etched 14, and the cathode or the supporting base 12 has either a water jacket 15 to keep the base cool with water or an appropriate electric heater to heat the base as well as an electrode plate or the electrostatic chucking device 16 with a pair of plane electrodes on the surface. The arrows in the figure indicate the direction of gas flow.

The electrode plates of the electrostatic chucking device 16 include a pair of plane electrodes 17 and 18 as the sectional and plan view shown in Figs. 6 and 7, respectively. For example, by the electric wiring as shown in Fig. 6, a voltage of approximately 1000 through 2000 volts is applied between the electrodes 17 and 18, and the material to be etched 14 is chucked to the supporting base 12 electrostatically, then the heat conductivity between the material to be etched 14 and the supporting base 12 is increased. The electrode plate 16 is constructed, for example, with aluminium electrodes 17 and 18 buried in an insulating layer 19 made of silicon gum.

The thickness of the first layer of the insulating layer 19 is preferably approximately 0.05 through 0.2 mm. The insulating layer 19 desirably has elasticity so that the insulating layer 19 can contact closely with the material to be etched. The resistors in the electric wiring of Fig. 6 are filters and prevent the high frequency electric field from interference with the external power source circuit. The resistance value may be determined sufficiently higher than plasma impedance. Instead of electrical resistance, coils can be used, and the impedance of the coil may be determined similarly as in the case of resistance. In Fig. 6 the reference numeral 20 shows a power switch and the reference numeral 21 shows a switch for leaking.

[Experiment 2]

In order to explain the effect of the method for dry etching according to the present invention, the results of an experiment using silicon wafers as the material to be etched in the apparatus of Fig. 4 are explained below.

The experiment is performed in the following steps. In the quartz chamber a silicon wafer is arranged as shown in Fig. 4 and sputter etching or reactive sputter etching is started. After initiating the discharge the temperature of the wafer is measured, when the generated heat quantity becomes equal to the loss of heat namely when the temperature of the wafer is balanced, the temperature of the wafer is obtained by either using or not using the electrode plate 16.

The electrode plate 16 used in experiment 2 has a pair of plane electrodes, for example made of aluminium as shown in Figs. 6 and 7, and polytetrafluoroethylene having a thickness of 0.1 mm is coated as an insulating layer on the surface of the electrodes. The results obtained from the experiment are as follows.

Sputter etching condition: Argon 13.33 Pa (0.1 Torr)
Applied electric power: 300 watts
(a) Balancing temperature of the wafer with electrode plate: 50 degrees centigrade
(b) Balancing temperature of the wafer without electrode plate: 230 degrees centigrade.

In a further experiment using the apparatus in Fig. 4 aluminium was etched with $CCl_4$.

Etching condition: $CCl_4$ 13.33 Pa (0.1 Torr), applied electric power 800 watts. In the above described condition the aluminium could be etched at a high etching rate of 3 micrometers/minute. While, in the condition without the electrode plate or electrostatic chucking device 16, when the applied electric power rises to at least 200 watts or above, the resist film on the wafer is changed in quality because of high temperature during the high rate of etching, thereby the etching rate had to be decreased to approximately 0.3 micrometers/minute.

[Experiment 3]

The examples in which the present invention is applied to barrel type plasma etching or microwave excited plasma etching are explained below. In the examples a wafer was located on a supporting base cooled by water, with the insertion of an electrode plate or an electrostatic chucking device therebetween and was etched under the condition of Argon 13.33 Pa (0.1 Torr) and an applied electric power of 300 watts by a barrel type plasma etching process, then the temperature of the wafer was balanced at 35 degrees centigrade. In the case without the electrode plate, the temperature of the wafer rises up to 120 degrees centigrade.

In the microwave excited plasma etching as well as the barrel type plasma etching, an excellent cooling effect was obtained by the method for dry etching according to the present invention as shown below.

Etching condition: Argon 13.33 Pa (0.1 Torr) applied electric power 300 watts
(a) Balancing temperature of the wafer with electrode plate: 60 degrees centigrade
(b) Balancing temperature of the wafer without electrode plate: 230 degrees centigrade.

As explained above, by using the present invention, the great amount of heat being generated at the wafer can be removed effectively, thereby the high rate of etching by the high electric power can be performed in the sputter etching, the reactive sputter etching and the plasma etching. Further, the method according to the present invention can be applied to the etching of conductive materials, semiconductors or insulating films on these materials. Also the method can be applied to cases in which the material to be etched is treated on the anode, the cathode or any portion in the plasma. Moreover, said electrode plate or said electrostatic chucking device can be applied to handling in either plasma or a vacuum.

When the material to be etched is to be held on its side or upside down, for example, the electrostatic chucking device is located on the supporting base positioned horizontally, the material to be etched is put thereon, then after the voltage is applied to the electrostatic chucking device and the material to be etched

6

is chucked to the supporting base, the orientation of the material to be etched can be decided by the rotation of 90 degrees or 180 degrees of the electrode portion in the dry etching apparatus. By using the above-mentioned handling, the defect of the etched pattern due to the attachment of dust can be improved considerably.

[Experiment 4]

In this experiment, the etching of an Aluminium-Copper (Al-Cu) alloy was attempted. The method of the experiment is explained below. The etching was performed using the etching apparatus in Fig. 4 heated with a heater at the electrode temperature of approximately 250 degrees centigrade. The heater was provided in the supporting base so that the nichrome wire of the heater is insulated from the supporting base with a ceramic such as alumina. In order not to transmit the high frequency electric power to the nichrome wire, it is recommended that the voltage is applied to the heater through coils as well as applying the voltage to the electrostatic chucking device through coils. Using $SiO_2$ as an etching mask, $CCl_4$ was used as the etching gas.

Comparing the result from the apparatus having the heater with the result from the apparatus having no heater, a granular residue remained on the material to be etched in the case of using no heater, while in the case of using a heater such the granular residue could not be found. This fact is explained according to the following consideration. Namely, it is supposed that the Al-Cu alloy is etched due to the following reactions.

$$Al+3Cl \cdot \rightarrow AlCl_3$$

$$Cu+2Cl \cdot \rightarrow CuCl_2$$

Also it is supposed that since the vapor pressure of $CuCl_2$ is very low, Cu or $CuCl_2$ remains if the temperature of the material to be etched is not raised by heating.

With all the electrostatic chucking devices described above, the attractive force is greatest when the electrodes cover the greatest possible portion of the area of contact between the material to be etched and the insulator, because equation (6) shows that the force F increases with increasing areas S1 and S2. The force F is also maximised when the areas of the two capacitors are equal, i.e. S1=S2 as shown above. Therefore the chuck is designed to satisfy these two criteria as closely as possible, as shown for example in figures 7, 8 and 9.

**Claims**

1. An electrostatic device for chucking a material having at least a conductive portion, comprising a sheet of insulator (2, 19) and a pair of plane electrodes (4, 5; 17, 18) positioned on a first of the two surfaces of the sheet of insulator in close contact with the sheet, the plane electrodes being electrically isolated from each other, and voltage being supplied between the pair of plane electrodes from an external voltage source such that the plane electrodes are capable of chucking the conductive material (3) on the second surface of the sheet of insulator, characterized in that the sum of the areas of the portions of the pair of plane electrodes (4, 5; 17, 18) which face the conductive material is approximately equal to the contact area between the said material (3) and the sheet of insulator (2, 19) when the material is chucked.

2. An electrostatic chucking device according to claim 1, wherein each of the plane electrodes is semi-circular in outline (Figure 7).

3. An electrostatic chucking device according to claim 1, wherein each of the plane electrodes two opposite quadrants of a circle (Figure 8), the four quadrants being symmetrically arranged about the centre point.

4. An electrostatic chucking device according to claim 1, wherein a first of the plane electrodes has a circular periphery and the other plane electrode is in the form of an annulus concentric with the first electrode (Figure 9).

5. An electrostatic chucking device according to any of claims 1 to 4, wherein the insulator has an elasticity such that the insulator can contact closely with the material to be etched.

6. An electrostatic device as defined in any of claims 1 to 5, wherein the pair of electrodes (17, 18, Figure 6) is embedded in the insulator (19).

7. An apparatus for dry etching of material having at least a conductive portion and using a sputter etching apparatus, a reactive sputter etching apparatus, or a plasma etching apparatus, comprising: a supporting base (12, Figure 4), the temperature of which is maintained at a predetermined value; an electrostatic chucking device (16) according to any one of claims 1 to 6 mounted on the supporting base for chucking the material to be dry etched; and an etching chamber (10) to which gases are supplied and to which electric power is applied to form a plasma for etching.

8. A method for dry etching a material having a conductive portion, comprising placing the material to be etched on an electrostatic device positioned on a supporting base (12, Figure 4) the temperature of which is maintained at a predetermined value, the electrostatic device having a sheet of insulator (2, 19) and a pair of plane electrodes (4, 5; 17, 18) positioned on one surface of the sheet of insulator in close

7

**0 049 588**

contact with the sheet, the plane electrodes being electrically isolated from each other, and a voltage being applied between the pair of plane electrodes of the electrostatic device from an external power source to cause the material to be chucked electrostatically to the opposite surface of the sheet of insulator and thereby indirectly fixed to the supporting base, characterized in that the sum of the area of the portions of the pair of plane electrodes (4, 5; 17, 18) facing the direction of the material (3) is approximately equal to the contact area between the material and the sheet of insulator when the material is chucked and in that the electrostatic device and supporting base are positioned in the etching chamber (10) of a sputter etching apparatus, reactive sputter etching apparatus, or a plasma etching apparatus, an etching gas is introduced into the said chamber and an electric field is formed in the chamber by power source to form a plasma.

9. A method for dry etching as defined in claim 8, using the sputter etching apparatus or the reactive sputter etching apparatus wherein the supporting base (12) is an electrode to which high frequency voltage (r.f.) is applied to form a plasma.

10. A method for dry etching as defined in claim 9 wherein the voltage of the external power source means is a D.C. voltage and is applied to the pair of plane electrodes through high-frequency eliminating filters.

**Patentansprüche**

1. Elektrostatische Vorrichtung zur Halterung eines Materials, das wenigstens einen leitenden Abschnitt hat, mit einem Isolatorblatt (2, 19) und einem Paar von ebenen Elektroden (4, 5; 17, 18), die auf einer ersten der beiden Oberflächen des Isolatorblattes in engem Kontakt mit diesem angeordnet sind, wobei die ebenen Elektroden voneinander elektrisch isoliert sind und eine Spannung zwischen den beiden ebenen Elektroden von einer äußeren Spannungsquelle so angelegt ist, daß die ebenen Elektroden das leitende Material (3) auf der zweiten Oberfläche des Isolatorblattes halten können, dadurch gekennzeichnet, daß die Summe der Flächen der Abschnitte des Paars von ebenen Elektroden (4, 5; 17, 18), welche dem leitenden Material zugewandt sind, etwa gleich der Kontaktfläche zwischen dem genannten Material (3) und dem Isolatorblatt (2, 19) ist, wenn das Material gehaltert ist.

2. Elektrostatische Halterungsvorrichtung nach Anspruch 1, bei welcher jede der ebenen Elektroden eine halbkreisförmige Außenlinie hat (Fig. 7).

3. Elektrostatische Halterungsvorrichtung nach Anspruch 1, bei welcher jede der ebenen Elektroden zwei gegenüberliegende Quadranten eines Kreises (Figur 8) umfaßt, wobei die vier Quadranten symmetrisch um den Mittelpunkt angeordnet sind.

4. Elektrostatische Halterungsvorrichtung nach Anspruch 1, bei welcher eine erste der ebenen Elektroden einen kreisförmigen Umfang und die andere ebene Elektrode die Form eines Ringes hat, der mit der ersten Elektrode konzentrisch ist (Figur 9).

5. Elektrostatische Halterungsvorrichtung nach einem der Ansprüche 1 bis 4, bei welcher der Isolator eine solche Elastizität hat, daß der Isolator in engen Kontakt mit dem zu ätzenden Material kommen kann.

6. Elektrostatische Vorrichtung nach einem der Ansprüche 1 bis 5, bei welcher das Paar von Elektroden (17, 18, Figur 6) in den Isolator (19) eingebettet ist.

7. Vorrichtung zur Trockenätzung von Material, das wenigstens einen leitenden Abschnitt hat, die eine Zerstäubungsätzvorrichtung, eine reaktive Zerstäubungsätzvorrichtung oder eine Plasmaätzvorrichtung verwendet, mit: einer tragenden Basis (12, Figur 4), deren Temperatur auf einem vorbestimmten Wert gehalten wird; einer elektrostatischen Halterungsvorrichtung (16) nach einem der Ansprüche 1 bis 6, die auf der tragenden Basis zur Halterung des trocken zu ätzenden Materials montiert ist; und einer Ätzkammer (10), welcher Gase zugeführt werden und welcher elektrische Leistung zugeführt wird, um ein Plasma für das Ätzen zu bilden.

8. Verfahren zur Trockenätzung eines Materials, das einen leitenden Abschnitt hat, bei welchem das zu ätzende Material auf eine elektrostatische Vorrichtung plaziert wird, die auf einer tragenden Basis (12, Figur 4) positioniert wird, deren Temperatur auf einem vorbestimmten Wert gehalten wird, die elektrostatische Vorrichtung ein Isolatorblatt (2, 19) und ein Paar von ebenen Elektroden (4, 5; 17, 18) umfaßt, die auf einer Oberfläche des Isolatorblattes in engem Kontakt mit dem Blatt angeordnet sind, die ebenen Elektroden voneinander elektrisch isoliert sind und eine Spannung von einer externen Leistungsquelle an das Paar von ebenen Elektroden der elektrostatischen Vorrichtung angelegt wird, um zu bewirken, daß das Material elektrostatisch an der gegenüberliegenden Oberfläche des Isolatorblattes gehalten und dadurch indirekt an der tragenden Basis fixiert wird, dadurch gekennzeichnet, daß die Summe der Flächen der Abschnitte des Paares von ebenen Elektroden (4, 5; 17, 18), welche in Richtung des Materials (3) weisen, etwa gleich der Kontaktfläche zwischen dem Material und dem Isolatorblatt ist, wenn das Material gehaltert ist, und daß die elektrostatische Vorrichtung und die tragende Basis in der Ätzkammer (10) einer Zerstäubungsätzvorrichtung, einer reaktiven Zerstäubungsätzvorrichtung, oder einer Plasmaätzvorrichtung angeordnet wird, und daß ein Ätzgas in die genannte Kammer eingeführt und ein elektrisches Feld in der Kammer durch die Energiequelle gebildet wird, um ein Plasma zu bilden.

9. Verfahren zur Trockenätzung nach Anspruch 8, bei welchem die Zerstäubungsätzvorrichtung oder die reaktive Zerstäubungsätzvorrichtung verwendet wird, in welcher die tragende Basis (12) eine Elektrode ist, welcher hochfrequente Spannung (r.f.) zugeführt wird, um ein Plasma zu bilden.

10. Verfahren zur Trockenätzung nach Anspruch 9, bei welchem die Spannung der externen

8

**0 049 588**

Energiequelleneinrichtung eine Gleichspannung ist und dem Paar von ebenen Elektroden durch Hochfrequenz eliminierende Filter zugeführt wird.

## Revendications

1. Dispositif électrostatique pour maintenir un matériau comportant au moins une partie conductrice, comprenant une feuille de matériau isolant (2, 19) et deux électrodes planes (4, 5; 17, 18) placées sur une première des deux surfaces de la feuille de matériau isolant en contact étroit avec la feuille, les électrodes planes étant électriquement isolées l'une de l'autre, et une tension étant fournie entre les deux électrodes planes à partir d'une source de tension extérieure de telle sorte que les électrodes planes sont capables de maintenir le matériau conducteur (3) sur la seconde surface de la feuille de matériau isolant, caractérisé en ce que la somme des surfaces des parties des deux électrodes planes (4, 5; 17, 18) faisant face au matériau conducteur est approximativement égale à la surface de contact entre le matériau (3) et la feuille de matériau isolant (2, 19) quand le matériau est maintenu.

2. Dispositif de maintien électrostatique selon la revendication 1, caractérisé en ce que chacune des électrodes planes est semi-circulaire de contour (Figure 7).

3. Dispositif de maintien électrostatique selon la revendication 1, caractérisé en ce que chacune des électrodes planes est constituée par deux quadrants opposés d'un cercle (Figure 8), les quatre quadrants étant disposés symétriquement autour du point central.

4. Dispositif de maintien électrostatique selon la revendication 1, caractérisé en ce qu'une première des électrodes planes à une périphérie circulaire et l'autre électrode plane a la forme d'un anneau concentrique avec la première électrode (Figure 9).

5. Dispositif de maintien électrostatique selon l'une quelconque des revendications 1 à 4, caractérisé en ce que le matériau isolant a une élasticité telle que le matériau isolant peut être en contact étroit avec le matériau à attaquer.

6. Dispositif de maintien électrostatique selon l'une quelconque des revendications 1 à 5, caractérisé en ce que les deux électrodes (17, 18 sur la Figure 6) sont enfouies dans le matériau isolant (19).

7. Appareil pour l'attaque à sec d'un matériau comportant au moins une partie conductrice et utilisant un appareil d'attaque par pulvérisation, un appareil d'attaque par pulvérisation réactive, ou un appareil d'attaque par plasma, comprenant: une base de support (12, Figure 4) dont la température est maintenue à une valeur prédéterminée; un dispositif de maintien électrostatique (16), selon l'une quelconque des revendications 1 à 6, monté sur la base de support pour maintenir le matériau à attaquer à sec; et une chambre d'attaque (10) à laquelle des gaz sont fournis et à laquelle une puissance électrique est appliquée pour former un plasma pour une attaque.

8. Procédé pour l'attaque à sec d'un matériau comportant une partie conductrice, consistant à placer le matériau à attaquer sur un dispositif électrostatique positionné sur une base de support (12, Figure 4) dont la température est maintenue à une valeur prédéterminée, le dispositif électrostatique comportant une feuille de matériau isolant (2, 19) et deux électrodes planes (4, 5; 17, 18) positionnées sur une surface de la feuille de matériau isolant en contact étroit avec la feuille, les électrodes planes étant isolées électriquement l'une de l'autre, et une tension étant appliquée entre les deux électrodes planes du dispositif électrostatique à partir d'une source de tension extérieure pour que le matériau soit maintenu électrostatiquement par rapport à la surface opposée de la feuille de matériau isolant et soit ainsi fixée indirectement à la base de support, caractérisé en ce que la somme des surfaces des parties des deux électrodes planes (4, 5; 17, 18) faisant face à la direction du matériau (3) est approximativement égale à la surface de contact entre le matériau et la feuille de matériau isolant quand le matériau est maintenu, et en ce que le dispositif électrostatique et la base de support sont placés dans la chambre d'attaque (10) d'un appareil d'attaque par pulvérisation, d'un appareil d'attaque par pulvérisation réactive, ou d'un appareil d'attaque par plasma, en ce qu'un gaz d'attaque est introduit dans la chambre et en ce qu'un champ électrique est formé dans la chambre au moyen d'une source de tension pour former un plasma.

9. Procédé pour l'attaque à sec selon la revendication 8, utilisant l'appareil d'attaque par pulvérisation ou l'appareil d'attaque par pulvérisation réactive, caractérisé en ce que la base de support (12) est une électrode à laquelle est appliquée une tension en haute fréquence (r.f.) pour former un plasma.

10. Procédé pour l'attaque à sec selon la revendication 9, caractérisé en ce que la tension de la source de tension extérieure est une tension en courant continu et en ce qu'elle est appliquée aux deux électrodes planes par l'intermédiaire de filtres éliminant les hautes fréquences.

# Fig. 1

# Fig. 2

# Fig. 3

# Fig. 4

## Fig. 5

## Fig. 6

*Fig. 7*

*Fig. 8*

## Fig. 9

## Fig. 10